# EUROPÄISCHE PATENTANMELDUNG

(11) **EP 2 094 000 A2**
(43) Veröffentlichungstag der Anmeldung: **26.08.2009**
(21) Anmeldenummer: 09153190.5
(22) Anmeldetag: 19.02.2009
(51) Int. Cl.: H04N 5/225, H01L 31/0232

(54) **Bilderfassungsvorrichtung einer Kamera**

(30) Priorität: 22.02.2008 DE 102008010587
(71) Anmelder: Silicon Micro Sensors GmbH, 01009 Dresden (DE)
(72) Erfinder: Busse, Erik, 04600, Altenburg (DE)
(74) Vertreter: Lippert, Stachow & Partner

(57) **Zusammenfassung**

Es wird eine Bilderfassungsvorrichtung einer Kamera angegeben, die einen elektronischen Sensorchip aufweist, der elektrisch mit einer Leiterplatte verbunden ist. Ein Objektiv der Bilderfassungsvorrichtung, das in einem Objektivträger angeordnet ist, ist relativ zu einer Imagerfläche des Sensorchips hinsichtlich Lage und Neigung ausgerichtet, indem die Lage und Neigung des Objektivs zu einer Auflagefläche des Objektivträgers definiert ist und besagte Auflagefläche des Objektivträgers auf dem Sensorchip flächig aufliegt, so dass die Imagerfläche von der Auflagefläche nicht überdeckt ist.

## Beschreibung

Die Erfindung betrifft eine Vorrichtung einer Kamera zur Bilderfassung. Die Vorrichtung umfasst einen Sensorchip, der eine optisch aktive Fläche aufweist, im Folgenden als Imagerfläche bezeichnet, und der entweder direkt oder durch Zwischenlegen einer Leiterplatte indirekt auf einem Träger angeordnet ist. Der Sensorchip weist Kontaktpads auf, über die der Sensorchip mit der Leiterplatte elektrisch verbunden ist. Dem Sensorchip ist ein Objektiv zur Abbildung der Umgebung auf den Sensorchip zugeordnet, wobei das Objektiv in einem Objektivträger gehalten und in seiner Lage und Neigung relativ zur Imagefläche ausgerichtet ist.

Derartige Kameras werden für verschiedene Anwendungen verwendet, um die Umgebung optisch zu erfassen, zu verarbeiten und auszuwerten und die so gewonnenen Daten z.B. zur Steuerung von Vorrichtungen oder Verfahren zu verwenden, auch zur Steuerung der Kamera selbst.

Der Aufbau einer solchen Kamera umfasst regelmäßig zumindest einen elektronischen Sensorchip, dem ein dem jeweiligen Anwendungsfall und auch der Auflösung des Sensor sowie der Größe der Imagerfläche angepasstes Objektiv zugeordnet ist. Der Sensorchip ist auf einer Leiterplatte montiert, auf der Signalleitungen, Versorgungsleitungen und gegebenenfalls zumindest Signalvorverarbeitungseinheiten angeordnet sind.

Die Leiterplatte einschließlich der beschriebenen Aufbauten ist auf einem Träger montiert. Über jedem Sensorchip mit dem entsprechend dem optischen System des Objektivs erforderlichen Abstand ist das Objektiv angeordnet. Es ist so auf Träger und Leiterplatte montiert, dass der Sensorchip vollständig umhüllt ist und Licht nur durch die Linsen auf den Sensorchip fällt. Gegebenenfalls weist das Objektiv dafür ein eigenes Gehäuse auf.

Der Träger und ebenso dessen Verbindungen zur Leiterplatte und zum Objektiv oder dessen Gehäuse muss für die verschiedenen Anwendungsfälle unterschiedliche mechanische, thermische, chemische und elektrische Anforderungen erfüllen, wobei insbesondere die mechanische Stabilität für die Verwendung in mobilen Vorrichtungen zu gewährleisten ist. Aus diesem Grund sind die Träger meist aus Metall gefertigt. Über den Träger ist die Kamera mit externen Vorrichtungen verbunden, die z.B. der Bewegung der Kamera dienen können, so dass zur Ausrichtung der Kamera relativ zu diesen externen Vorrichtungen eine Ebene des Trägers als eine Referenzfläche definiert ist, zu welcher der Sensorchip und das Objektiv ausgerichtet sind.

Eine exakte Ausrichtung von Sensorchip und Objektiv zueinander ist eine wesentliche Voraussetzung für eine auswertbare Bildqualität. Diese Ausrichtung umfasst zum einen die laterale Ausrichtung beider Komponenten, über die insbesondere die Bildqualität im Randbereich der Imagerfläche und somit die Größe der auswertbaren Ergebnisse liefernden Imagerfläche bestimmt. Die Ausrichtung umfasst ebenso die Neigung beider Komponenten zueinander, die über die Neigung jeder einzelnen Komponente zur selben Referenzfläche feststellbar ist. Auch die Neigung der Imagerfläche allein zur Referenzfläche hat einen Einfluss auf das aufgenommene Bild und dessen Auswertung, da eine Bewegung oder Positionierung der Kamera und damit der Imagerfläche, wie oben dargelegt, bezogen auf die Referenzfläche erfolgt.

Sind Imagerfläche und Referenzfläche zueinander gekippt, ist das aufgenommene Bild von einer Drehung der Kamera um seine optische Achse abhängig. Dieser Effekt ist als "Tild" oder "yaw pitch and roll" bekannt und kann nur durch eine exakte und sehr aufwendige parallele Ausrichtung der Imagerfläche zur Referenzfläche vermieden werden. Diese Ausrichtung ist folglich auch für die Neigung des Objektivs zur Referenzfläche in der gleichen Genauigkeit herzustellen und insbesondere während der gesamten Betriebsdauer der Kamera unabhängig von thermischen und mechanischen Belastungen aufrechtzuerhalten. Dies erweist sich aufgrund der unterschiedlichen räumlichen Ausdehnungen von Sensorchip und Objektivträger oft als schwierig.

Verluste in der Bildqualität können des Weiteren z.B. durch eine Verschiebung des Sensorchips und des Objektivs relativ zueinander auftreten. Zum anderen sind auch die Beeinträchtigungen durch Streulicht möglich, welches durch defekte Verbindungen zwischen dem Träger und dem Objektiv auf den Sensorchip fällt. Die Verbindung zwischen Träger und Objektiv sind meist Klebeverbindungen, die infolge der thermischen Ausdehnungen von Träger und Objektiv abreißen können.

Der Erfindung liegt somit die Aufgabe zugrunde, eine Kamera anzugeben, die eine zeitlich stabile Optik und insbesondere eine zeitlich stabile Ausrichtung zwischen Objektiv und Sensorchip auch bei thermischer und mechanischer Belastung gewährleistet.

Mit der unten beschriebenen Bilderfassungsvorrichtung wird die Lage und die Neigung des Objektivs relativ zur Imagerfläche durch deren direkte Verbindung miteinander definiert und ist so von der Lage und dem thermischen oder mechanischen Verhalten von irgendwelchen Verbindungselementen zwischen beiden Komponenten entkoppelt. Über die Definition einer Auflagefläche am Objektivträger, zu der die Lage des Objektivs definiert ist, und den direkten flächigen Kontakt zur Oberseite des Chips, welche die Imagerfläche aufweist, ist die Lage des Objektivs zur Lage des Sensorchips und damit auch der Imagerfläche eindeutig definiert. Die Eindeutigkeit der Lage betrifft sowohl die laterale Ausrichtung als auch die Neigung, die beide wie oben dargelegt Einfluss auf die Qualität und Stabilität der Bildaufnahme hat. Mit der beschriebenen Bilderfassungsvorrichtung werden Verschiebungen oder Neigungen durch irgendwelche Verbindungselemente zwischen Objektivträger und Imagerfläche, wie z.B. Kleber sowohl bei der Montage als auch im Betrieb vermieden.

Darüber hinaus besteht über die definierte Lage des Sensorchips zu einer Referenzfläche der Bilderfassungsvorrichtung auch eine definierte Lage des Objektivs zu dieser Referenzfläche. Eine solche Referenzfläche kann in Abhängigkeit von dem weiteren Aufbau der Kamera und deren Montage in einer externen Vorrichtung beliebig gewählt werden. Z.B. kann dies die Montagefläche eines Trägers sein, auf welchem der Sensorchip direkt oder unter Zwischenlegen einer Leiterplatte indirekt montiert ist. Um den Einfluss von Verbindungselementen auf die Lage der Auflagefläche relativ zur Referenzfläche auch hier zu vermindern kann als Referenzfläche ebenso eine Oberfläche der Leiterplatte dienen. Sofern die relative Lage der Auflagefläche zu einer beliebigen anderen Fläche der Kamera z.B. durch geeignete Hilfsmittel thermisch und mechanisch stabil definiert werden kann, ist auch eine solche Fläche der Kamera als Referenzfläche geeignet.

Über die Gestaltung eines Objektivträgers gestattet es gleichermaßen, in den Objektivträger Elemente zu integrieren, die eine, gegebenenfalls auch automatisierte, Montage des Objektivs in der richtigen Position und mit dem richtigen Abstand zum Sensorchip zu ermöglichen und diese Position dauerhaft gewährleisten. Solche Elemente sind z.B. Abstandshalter, die einen definierten Abstand zwischen dem Objektivträger und dem Träger einstellen, so dass das optische System des Objektivs genau auf den Sensorchip eingestellt ist und dessen Abstand über die gesamte Sensorfläche einheitlich ist. Gleichermaßen sind auch Führungselemente zu integrieren, die eine Entsprechung im Träger aufweisen können, so dass die laterale Position des Objektivs zum Sensorchip definiert ist.

Die Erfindung soll nachfolgend anhand eines Ausführungsbeispieles näher erläutert werden. In den zugehörigen Zeichnungen zeigt
- Fig. 1: eine Ausführungsform einer Bildaufnahmevorrichtung, die direkt auf einem Träger montiert ist, in Schnittdarstellung;
- Fig. 2: eine Draufsicht auf den Sensorchip gemäß Fig. 1 und

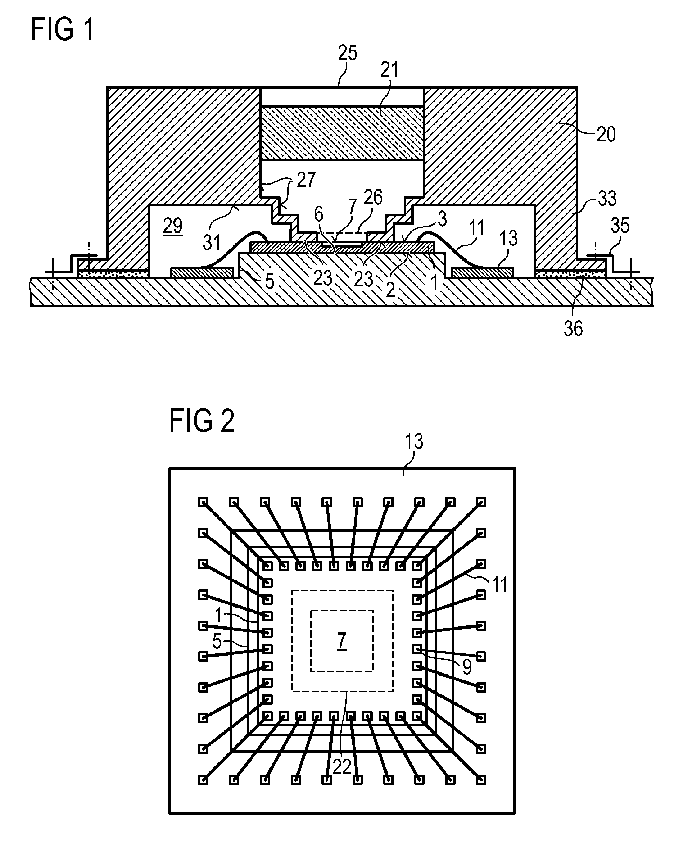

- Fig. 2: eine weitere Ausführungsform einer Bildaufnahmevorrichtung, die mittels einer Leiterplatte auf einem Träger montiert ist, in Schnittdarstellung.

Die Bildaufnahmevorrichtung gemäß Fig. 1 umfasst einen plattenartigen Träger 4, der im vorliegenden Ausführungsbeispiel aus Edelstahl ist. Der Träger 4 weist einen Podest 5 auf, auf welchem ein elektronischer Sensorchip 1 mit seiner Unterseite 2 aufliegt. Die Auflagefläche des Podests 5 ist etwas größer als der Sensorchip 1.

Der Sensorchip 1 umfasst in seiner Oberseite 3 eine optisch aktive Fläche, die Imagerfläche 7 auf, die zentral und mit einem Abstand zu den Außenkanten des Sensorchips 1 angeordnet ist. An seinen Außenkanten weist der Sensorchip 1 Reihen von Kontaktpads 9 auf, mit denen der Sensorchip 1 mittels flexibler Verbinder 11, im Ausführungsbeispiel Drahtbrücken mit einer Leiterplatte 13 elektrisch verbunden ist.

Die Leiterplatte 13 umgibt das Podest 5 vollumfänglich, indem die Leiterplatte 13 eine Aussparung aufweist, die in Größe und Gestalt dem Podest 5 angepasst ist und überall einen geringen Abstand zum Podest einhält (Fig. 2).

Über die Leiterplatte wird die Spannungsversorgung der einen oder weiterer, nicht dargestellter Bilderfassungsvorrichtungen der Kamera, sowie die Steuerung und Signalverarbeitung realisiert oder zumindest die Vorverarbeitung der von dem oder den Sensorchips 1 empfangenen Signale, zu deren Weiterleitung an eine Auswertungseinheit. Zu diesem Zweck ist der Sensorchip 1 mit der Leiterplatte 13 elektrisch verbunden. Abweichend von der elektrische Verbindung im Ausführungsbeispiel gemäß Fig. 1 und Fig. 2 können auch andere der bekannten Verbindungstechnologien in Frage kommen, je nach Aufbau und Funktionalität des Sensorchips 1.

Entsprechend der zu realisierenden Aufgabe weist die Leiterplatte 13 z.B. eine elektronische Schaltung (nicht näher dargestellt) mit integrierten Schaltkreisen, aktiven und passiven Schaltungselementen und den dafür erforderlichen Leiterzügen sowie Leiterbahnen (nicht näher dargestellt) auf, zur Signalleitung zu und von dem einen oder mehr Sensorchips 1 sowie zur Spannungsversorgung des oder der Sensorchips 1. Eine elektronische Schaltung umfasst z.B. auch die Steuerung von mehr als einer Bilderfassungsvorrichtung unter anderem zur synchronen Aufnahme der Bilder.

Fig. 2, die in der Draufsicht den Sensorchip 1, das Podest 5 und einen Abschnitt der Leiterplatte 13 darstellt, sind unter anderem die Anordnung von Kontaktpads 9 und von flexiblen Verbinder 11 in Bezug auf die Imagerfläche 7 zu entnehmen. Deren Größenverhältnis und Lage ist zueinander ist so realisiert, dass zwischen beiden eine Fläche frei bleibt (gestrichelt dargestellt), welche die Imagerfläche 7 umgibt und auf der ein Objektivträger 20 mit seiner Auflagefläche 23 positionierbar ist.

Diese Fläche soll im Folgenden als Auflagebereich 22 bezeichnet sein, wobei es selbstverständlich ist, dass die Lage, Gestalt und Größe des Auflagebereichs 22 von der dargestellten Lage, Gestalt und Größe abweichen kann. Diese wird unter anderem in Abhängigkeit von der Größe der benötigten Auflagefläche 23 und von der Größe der Imagerfläche 7 abhängen. Auch die von der Lage und Anzahl der Kontaktpads 9 hat Einfluss, wobei in anderen Ausführungsformen auch andere Kontaktierungsmöglichkeiten zwischen Sensorchip 1 und Leiterplatte 13 realisiert sein können, bei denen auf der Oberseite 3 keine Kontaktpads 9 angeordnet sind. Z.B. kann der Sensorchip 1 gehäust sein und an seiner seitlichen Umfassungsfläche oder seiner Unterseite 2 anders gestaltete Kontakte aufweisen.

Der Gestaltung des Auflagebereichs 22 definiert keinesfalls die Gestalt der Auflagefläche 23, sondern lediglich den Bereich auf der Oberseite 3 des Sensorchips 1, in dem die Auflagefläche 23 des Objektivträgers 20 auflegbar ist. Die Auflagefläche 23 selbst kann wie in Fig. 2 dargestellt die Imagerfläche 7 vollumfänglich umschließen, sich aber ebenso aus mehreren Teilflächen zusammensetzen, die beabstandet zueinander sind. Dies ist z.B. dann der Fall, wenn der Objektivträger 20 mittels separater Füße auf dem Sensorchip 1 positioniert wird. Während bei einer vollumfänglichen Auflage des Objektivträgers 20 um die Imagerfläche 7 Verluste des einfallenden Lichts und unbeabsichtigte Reflexiionen in der Umgebung der Imagerfläche 7 vermieden werden können, können bei der Positionierung z.B. mittels einzelner Füße geeignete Maßnahme erfolgen, um solche Effekte zu vermeiden.

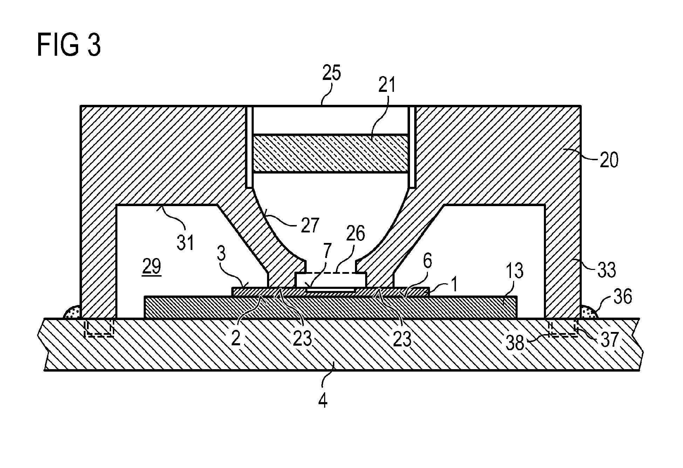

Über dem Sensorchip 1 und mit einem Abstand zu diesem ist mittels des Objektivträgers 20 ein Objektiv 21 angeordnet (Fig. 1). Der Objektivträger 20 der Bilderfassungsvorrichtung hält, schützt und positioniert ein Objektiv 21. Als Objektiv 21 soll ein optisches System bezeichnet sein, welches zur Abbildung der Objekte verschiedene optische Elemente wie Linsen oder Spiegel oder andere umfasst und ein Objekt auf der Imagerfläche 7 des Sensorchips 1 abbildet. In Fig. 1 und ebenso in Fig. 3 ist das Objektiv 21 zur besseren Übersicht jedoch lediglich schematisch dargestellt. Für die beschriebene Bilderfassungsvorrichtung sind auch Standardausführungen von Objektiven 21 verwendbar.

Der Fokus des Objektivs 21 kann in verschiedenen Ausführungsformen im eingebauten Zustand einstellbar sein, so dass erst nach dem Einbau des Objektivs 21 entsprechend dem dann vorliegenden Abstand zwischen Objektiv 21 und Sensorchip 1 die scharfe Abbildung von Gegenständen bestimmter Entfernungen eingestellt wird. Aufgrund der Positionierung des Objektivträgers 20 auf dem Sensorchip 1 und der damit definierten Entfernung zwischen beiden ist auch ein Fix-Fokus-System anwendbar, bei dem der Fokus fest eingestellt ist.

Eine Ausführungsform des Objektivträgers 20 umfasst gemäß Fig. 1 zwischen dem Objektiv und seiner Auflagefläche eine so genannte Lichtfalle, mit der das durch die Lichteinfallfläche 25 eingetretene und durch das Objektiv 21 hindurch getretene Licht zur Lichtaustrittsfläche 26 der Lichtfalle geleitet wird. Die Lichtaustrittsfläche 26 ist in der dargestellten Ausführungsform nur geringfügig größer als die Imagerfläche 7 und liegt dieser gegenüber. Die Lichtfalle weist für eine gute Lichtausbeute eine sich zur Lichtaustrittsfläche 26 stufenförmige verjüngende Form auf. Auch andere Formen von Lichtfallen mit vergleichbaren Reflexionseigenschaften der Innenfläche der Lichtfalle sind verwendbar. In Fig. 3 ist alternativ eine sich parabelförmig verjüngende Lichtfalle dargestellt. Zur Vermeidung störender Lichtreflexe ist die innere Oberfläche 27 der Lichtfalle mit einer diffus reflektierenden Struktur (nicht dargestellt) versehen. Sofern die Lichtausbeute für den Anwendungsfall oder für den verwendeten Sensorchip 1 ausreichend ist oder störende Reflexionen nicht auftreten oder beides, kann in einer Ausführungsform die Bilderfassungsvorrichtung auch ohne Lichtfalle ausgeführt sein.

Die Auflagefläche 23 wird in der Ausführungsform gemäß Fig. 1 durch die Außenfläche der untersten, parallel zur Oberseite 3 des Sensorchips 1 verlaufenden Stufe der Lichtfalle gebildet. Sie umgibt die Imagerfläche 7 vollumfänglich und vermeidet so einen seitlichen Lichteinfall auf die Imagerfläche 7.

Als Referenzfläche können in der Ausführungsform verschiedene Flächen dienen, die eine definierte Lage zum Träger 4 aufweisen, über den die Positionierung der Bilderfassungsvorrichtung erfolgen kann, oder eine definierte Lage zur Oberseite 3 des Sensorchips 1. Durch letzteren Bezug weist die Referenzfläche gleichzeitig eine definierte Lage zur Auflagefläche 23 sowie zur Imagerfläche 7 auf, die mit der Oberseite 3 des Sensorchips 1 in einer gemeinsamen oder zumindest in parallelen Ebenen liegen. Aus diesem Grund kann die Podestfläche 6 oder die Oberseite 3 selbst als Referenzfläche dienen. Selbstverständlich können auch weitere Flächen als Referenzfläche dienen, die parallel oder in einem definierten Winkel zur Auflagefläche 23 liegen.

Der Objektivträger weist auf seiner dem Träger 4 zugewandten Seite eine Senke 29 auf, deren Grundfläche 31 größer ist als das Podest 5, auf welchem der Sensorchip 1 angeordnet ist und ebenso größer als die Leiterplatte 13, zumindest in jener Ausdehnung, die in Fig. 1 parallel zur Zeichnungsebene liegt. In die Senke 29 ragt die Lichtfalle hinein. Die äußere Form der Lichtfalle verläuft wie die innere Form gleichermaßen stufenförmig, mit zum Sensorchip 1 hin kleiner werdendem Abstand. Damit ist im Bereich über den Kontaktpads 9 an den Außenkanten des Sensorchips 1 genügend Freiraum geschaffen, um die Kontaktierung der Kontaktpads 9 durch Drahtbrücken als flexible Verbinder 11 zu realisieren, ohne irgendeinen Kontakt der Drahtschleife mit der Außenfläche der Lichtfalle. Sofern in anderen Ausführungsformen durch andere Maßnahmen ein solcher Kontakt vermieden wird oder andere Kontaktierungen des Sensorchips 1 realisiert sind, ist auch eine andere Gestaltung der in die Senke ragenden Außenfläche der Lichtfalle möglich.

Der Objektivträger 20 ist so auf dem Träger 4 angeordnet, dass sich die Senke 29 über das Podest 5, den Sensorchip 1 und einen Teil der Leiterplatte 13 wölbt, mit einem definierten Abstand zu Leiterplatte 13 und Podest 5. Die Tiefe der Senke 29 ist im Ausführungsbeispiel gemäß Fig. 1 ungefähr so groß wie die Höhe des Podest 5, des Sensorchips 1 und des in die Senke 29 ragenden Teils der Lichtfalle gemeinsam. Auf diese Weise stützt sich jene, die Senke 29 umgebende Außenwandung 33 des Objektivträgers 20 auf dem Träger 4 ab. Sofern eine Fuge verbleibt kann die, wie unten noch zu beschreiben ist, mit einem Fugenmaterial geschlossen werden, das solche mechanischen, chemischen oder optischen Eigenschaften aufweist, wie es Anwendungsfälle der Bilderfassungsvorrichtung oder deren Umgebungsbedingungen erfordern.

In dem Bereich des Objektivträgers 20, in dem die Leiterplatte 13 aus dem Objektivträger 20 herausragt (nicht dargestellt) ist die Außenwandung 33 des Objektivträger 20 entsprechend ausgespart, so dass der Anschluss der Außenwandung 33 des Objektivträgers zur Leiterplatte 13 auch dort durch einen Kontakt oder durch eine Fuge hergestellt ist.

Die Einstellung der genauen lateralen Position des Objektivträgers 20 und somit der Auflagefläche zum Sensorchip 1 und auch dessen winklige Ausrichtung, bezogen auf die Drehachse in Richtung der optischen Achse der Vorrichtung, sind durch geeignete Justiermittel möglich (nicht dargestellt), die am Objektivträger 20 und korrespondierend dazu am Träger 4 oder alternativ oder ergänzend am Sensorchip 1 angeordnet sein können. Durch die Anzahl, Lage und Gestaltung solcher Justiermittel ist es auch möglich, eine eindeutige Zuordnung eines bestimmten Objektivträgers 20 zu einer Bildaufnahmevorrichtung einer bestimmten Kamera und zu seiner exakten Position zu definieren, so dass dessen Montage zumindest auch teilautomatisiert möglich ist.

In dem in Fig. 1 dargestellten Ausführungsbeispiel erfolgt die Fixierung des Objektivträgers 20 auf dem Träger 4 durch geeignete Haltemittel 35, wie z.B. Klemmen, Schrauben oder ähnlichem. Mit Hilfe der Haltemittel 35 wird der Objektivträger 20 in Richtung Träger 4 und gleichzeitig die Auflagefläche 23 gezogen. Durch die Einstellung der Höhe der Senke 29 im Verhältnis zur Gesamthöhe der oben genannten Komponenten in der Senke 29, wird eine definierte Kraft eingestellt, mit der die Auflagefläche 23 auf den Sensorchip 1 gepresst wird. Um Höhentoleranzen oder thermische oder mechanische Beanspruchungen auszugleichen, kann zwischen der Außenwandung 33 und dem Träger 4 als Fugenmaterial 36 eine nachgiebige Schicht 36 angeordnet sein, die den Anpressdruck zwischen Auflagefläche 23 und Sensorchip 1 auf ein definiertes Maß begrenzt. Eine solche nachgiebige Schicht 36 kann durch einen Kleber oder ein anderes geeignetes Material realisiert sein.

Alternativ zu dem beschriebenen Objektivträger 20, welcher einen Hohlraum um den Sensorchip 1 bildet, kann der Objektivträger auch nur auf dem Sensorchip 1 aufliegen, z.B. wenn ein entsprechendes Chipgehäuse oder ein Trägersubstrat des Sensorchips 1 eine solche Montage erlaubt. Auch das Abstützen des Objektivträgers 20 mittels einzelner Stützen auf dem Träger 4 oder der Leiterplatte 13 oder beiden ist möglich.

Fig. 3 stellt eine weitere Ausgestaltung einer Bilderfassungsvorrichtung dar. In dieser Ausführungsform ist der Sensorchip 1 auf einer Leiterplatte 13 montiert und mittels dieser Leiterplatte 13 auf einem Träger 4. Diese Ausgestaltung kann z.B. bei verschiedenen Verbindungstechnologien zwischen Sensorchip 1 und Leiterplatte 13 zur Anwendung kommen, bei denen keine flexiblen Verbinder 11 verwendet werden sollen. Darüber hinaus sind auch verschiedene Vorfertigungen dieser Verbindung realisierbar. Gemäß Fig. 3 ist die Leiterplatte 13 auf einem plattenförmigen Träger 4 montiert, der kein Podest aufweist. Als Referenzfläche kann sich in dieser Ausführungsform z.B. die Oberseite 3 des Sensorchips 1 oder die parallel dazu liegende Oberseite der Leiterplatte 12 eignen.

Neben dem abweichenden Aufbau von Sensorchip 1 und Leiterplatte 13 auf dem Träger 4 unterscheidet sich die Ausführungsform gemäß Fig. 3 von der in Fig. 1 durch die Form der Lichtfalle, die im Objektivträger integriert ist. Ihre Innenfläche weist eine zur Imagerfläche 7 hin fallende Parabelform auf und endet mit einem Abstand über dem Sensorchip 1. Die Auflagefläche 23 wird hier durch die Grundfläche von drei oder mehr Füßen am Fuß der Lichtfalle gebildet, die auch den Abstand der Lichtfalle zur Imagerfläche 7 einstellen. Die Auflagefläche 23 kann alternativ zur dargestellten Form auch durch drei oder mehr nahezu punktförmige Flächen gebildet sein, da bekanntlich eine Drei-Punkt-Lagerung eine sehr stabile Lagerung ist. Alternativ kann eine solche Anordnung des Objektivträgers 20 auf Füßen oder ähnlichem auch bei einem Objektivträger 20 ohne Lichtfalle erfolgen.

Die Verbindung des Objektivträgers 20 zum Träger 4, erfolgt auch hier über die Außenwandung 33 des Objetivträgers 20, die sich neben der Leiterplatte 13 auf dem Träger 4 abstützt. Zur lateralen und winkligen Ausrichtung des Objektivträgers 20 weist der Objektivträger in der dargestellten Ausführungsform an seiner Unterseite verteilt mehrere Führungsstifte 37 auf, die in korrespondierende Aussparungen 38 im Träger 4 eingreifen und in diesen verklebt sein können.

Eine Fuge zwischen der Außenmwandung 33 und dem Träger 4 oder der Leiterplatte 13 ist mit nachgiebigem Fugenmaterial 36 geschlossen, so dass aufgrund der optisch dichten Materialien des Objektivträgers 20 und des Fugenmaterials 36 der Hohlraum, der auch hier um den Sensorchip 1 besteht, optisch dicht ausgebildet ist. Der einzig mögliche Strahlungseinfall erfolgt durch das über dem Sensorchip 1 positionierte Objektiv 21. Die optische Dichtheit erstreckt sich nicht nur auf das sichtbare Licht, sondern kann sich auch auf alle die Wellenlängenbereiche beziehen, die für die Erfassung der Umgebung in dem jeweiligen Anwendungsfall verwendbar ist. Ist die optische Abdichtung nicht erforderlich oder durch andere Komponenten der Kamera realisiert, können anstelle der umlaufenden Außenwandung 33 des Objektivträgers 20 auch andere Bauteile zur Montage des Objektivträgers 20 auf dem Träger 4 oder alternativ auf der Leiterplatte 13 verwendet werden, wie z.B. Stützen oder Klammern oder ähnliches.

Die Verwendung von nachgiebigem Fugenmaterial 36, das als Kleber gleichzeitig den Objektträger 20 auf dem Träger 4 fixieren kann, definiert die Kraft, mit der die Auflagefläche 23 auf den Sensorchip gepresst wird. Zur Einstellung der Kraft über die Höhen der miteinander verbundenen Komponenten der Bilderfassungsvorrichtung wird auf die obigen Ausführungen verwiesen. Neben der Fixierung ermöglicht eine solche Fuge mit nachgiebigem Fugenmaterial 36 den Ausgleich von thermisch bedingten Spannungen zwischen den meist unterschiedlichen Materialien von Träger 4 und Objektivträger 20.

### Bezugszeichenliste

- 1: Sensorchip
- 2: Unterseite
- 3: Oberseite
- 4: Träger
- 5: Podest
- 6: Podestfläche
- 7: Imagerfläche
- 9: Kontaktpads
- 11: flexible Verbinder
- 13: Leiterplatte
- 20: Objektivträger
- 21: Objektiv
- 22: Auflagebereich
- 23: Auflagefläche
- 25: Lichteinfallfläche
- 26: Lichtaustrittsfläche
- 27: innerer Oberfläche
- 29: Senke
- 31: Grundfläche
- 33: Außenwandung
- 35: Haltemittel
- 36: Fugenmaterial
- 37: Führungsstifte
- 38: Aussparungen

## Patentansprüche

1. Bilderfassungsvorrichtung einer Kamera mit einem elektronischen Sensorchip (1), der eine optisch aktive Fläche aufweist, nachfolgend als Imagerfläche (7) bezeichnet, und der elektrisch mit einer Leiterplatte (13) verbunden ist, und mit einem Objektiv (21), das in einem Objektivträger (14) angeordnet und dessen Lage und Neigung relativ zur Imagerfläche (7) ausgerichtet ist, **dadurch gekennzeichnet, dass** die Lage und Neigung des Objektivs (21) zu einer Auflagefläche (23) des Objektivträgers (14) definiert ist und besagte Auflagefläche (23) des Objektivträgers (14) auf dem Sensorchip (1) flächig aufliegt, so dass die Imagerfläche (7) von der Auflagefläche (23) nicht überdeckt ist.

2. Bilderfassungsvorrichtung nach Anspruch 1, **dadurch gekennzeichnet, dass** der Objektivträger (14) eine tubusförmige Lichtfalle umfasst, mit einer verglichen zur Imagerfläche (7) vergrößerten Lichteinfallfläche (25), einem zur Imagerfläche (7) hin kleiner werdendem Innenquerschnitt und einer diffus reflektierenden Tubusinnenfläche, wobei die kleinere der beiden Grundflächen des Tubus der Lichtfalle die Auflagefläche (23) bildet.

3. Bilderfassungsvorrichtung nach einem der vorstehenden Ansprüche, **dadurch gekennzeichnet, dass** die Auflagefläche (23) die Imagerfläche (7) vollständig umgibt.

4. Bilderfassungsvorrichtung nach einem der vorstehenden Ansprüche, **dadurch gekennzeichnet, dass** die Auflagefläche (23) auf dem Sensorchip (1) zwischen der Imagerfläche (7) und Kontaktpads (9) des Sensorchips (1) aufliegt, die auf der Oberseite (3) des Sensorchips (1) zur elektrischen Kontaktierung des Sensorchips (1) angeordnet sind.

5. Bilderfassungsvorrichtung nach einem der vorstehenden Ansprüche, **dadurch gekennzeichnet, dass** der Sensorchip (1) direkt auf einem Träger (4) montiert ist und die elektrische Verbindung zwischen dem Sensorchip (1) und der Leiterplatte (13) mittels flexibler Verbinder (11) hergestellt ist.

6. Bilderfassungsvorrichtung nach Anspruch 5, **dadurch gekennzeichnet, dass** die Außenkontur der Lichtfalle mit zunehmender Entfernung zum Sensorchip (1) betrachtet einen treppenartigen Aufbau mit ansteigendem Außenquerschnitt aufweist.

7. Bilderfassungsvorrichtung nach einem der Ansprüche 1 bis 5, **dadurch gekennzeichnet, dass** der Sensorchip (1) auf einer Leiterplatte (13) und mittels der Leiterplatte (13) auf einem Träger montiert ist.

8. Bilderfassungsvorrichtung nach einem der vorstehenden Ansprüche, **dadurch gekennzeichnet, dass** der Objektivträger (14) Haltemittel (35) aufweist, mit denen der Objektivträger (14) auf dem Träger derart befestigt ist, dass die Auflagefläche (23) mit einer definierten Kraft auf den Sensorchip (1) gepresst wird.

9. Bilderfassungsvorrichtung nach Anspruch 7, **dadurch gekennzeichnet, dass** der Objektivträger (14) Haltemittel (35) aufweist, mit denen der Objektivträger (14) auf der Leiterplatte (13) derart befestigt ist, dass die Auflagefläche (23) mit einer definierten Kraft auf den Sensorchip (1) gepresst wird.

10. Bilderfassungsvorrichtung nach einem der vorstehenden Ansprüche, **dadurch gekennzeichnet, dass** die Auflagefläche (23) eine nachgiebige Schicht (36) aufweist.
